# EUROPÄISCHE PATENTSCHRIFT

(11) **EP 3 325 988 B1**
(45) Veröffentlichungstag und Bekanntmachung des Hinweises auf die Patenterteilung: **30.03.2022**
(21) Anmeldenummer: 16744354.8
(22) Anmeldetag: 22.07.2016
(51) Int. Cl.: G01R 31/364, G01R 31/382, H01R 4/10, H01R 4/50, G01R 15/20, H01R 11/28

(54) **SENSOREINRICHTUNG ZUM MESSEN EINES STROMDURCHFLUSSES MIT UNIVERSELLEM MASSENKONTAKTELEMENT**
SENSOR DEVICE FOR MEASURING A CURRENT FLOW HAVING A UNIVERSAL GROUND CONTACT ELEMENT
ENSEMBLE CAPTEUR POUR MESURER LE PASSAGE DE COURANT COMPRENANT UN ÉLÉMENT DE MISE À LA MASSE UNIVERSEL

(30) Priorität: 24.07.2015 DE 102015214069; 29.09.2015 DE 102015218794
(43) Veröffentlichungstag der Anmeldung: 30.05.2018
(73) Patentinhaber: Continental Automotive GmbH, 30165 Hannover (DE)
(72) Erfinder: FRENZEL, Henryk, 93059 Regensburg (DE)
(74) Vertreter: Continental Corporation
(86) Internationale Anmeldenummer: PCT/EP2016/067484
(87) Internationale Veröffentlichungsnummer: WO 2017/016993

(56) Entgegenhaltungen:
- DE-A1-102004 013 659
- DE-A1-102007 057 501
- DE-A1-102009 000 827
- DE-A1-102013 011 967

## Beschreibung

Die Erfindung betrifft eine Sensoreinrichtung zum Messen eines Stromdurchflusses nach Anspruch 1.

In vielen elektronischen Produkten ist es notwendig Ströme exakt zu ermitteln bzw. zu messen. Solche Messungen können beispielsweise über Hall-Sensoren oder mit Hilfe eines Messwiderstands vorgenommen werden. Bei der Messung mit einem Messwiderstand, auch als Shunt bezeichnet, wird die Stromstärke über den Spannungsabfall gemessen, der bei einem Stromfluss über dem bekannten Messwiderstand auftritt.

Ein Anwendungsbeispiel hierfür ist ein Batteriesensor, der den Zustand einer Fahrzeugbatterie und deren Stromfluss überwacht. Der Messwiderstand ist dabei zwischen dem Kontaktelement in Form einer Batterieklemme und dem Massenkontaktelement, das über ein Kabel mit dem Fahrzeugchassis verbunden ist, angeordnet.

Dabei ist das Massenkontaktelement als Schnittstelle an eine bestimmte Variante eines Masseanschlusses angepasst. Hieraus ergibt sich jedoch das Problem, dass durch die Variantenvielfalt der Masseanschlüsse hohe Kosten bei Logistik und Herstellung des Batteriesensors, insbesondere des Massenkontaktelements entstehen. Darüber hinaus haben bestimmte Varianten hinsichtlich ihrer speziellen Schnittstelle eine verringerte Leitfähigkeit, bzw. können leichter zerstört oder unbrauchbar werden. Zu den üblichen Masseanschlüssen gehören beispielsweise solche, die einen Bolzen mit Gewinde aufweisen, andererseits solche, die ein Blech mit angeschlossenem Massekabel umfassen.

Die Druckschrift US 2007/0025065 A1 offenbart eine Befestigungseinrichtung für einen Stromsensor, welcher nach dem Hall-Prinzip arbeitet. Der Stromsensor wird zwischen dem Minuspol einer Batterie und einem Erdungselement angebracht. Ein Erdungskabel, welches an seinem ersten Ende an den Minuspol der Batterie angeschlossen ist, weist an seinem zweiten Ende einen ringförmigen Kabelschuh auf. Der ringförmige Kabelschuh wird mithilfe eines Schrauben-Mutter-Befestigungselementes an dieses Befestigungselement geklemmt. Durch das Festziehen des Befestigungselementes werden die Schraube, die Unterlegscheibe, der Kabelschuh des Erdungskabels und der Sensor aneinander gepresst. Dabei wird eine elektrisch leitende Verbindung des Erdungskabels mit dem Befestigungselement hergestellt. Ferner ist das Befestigungselement mit dem Erdungselement elektrisch leitend verbunden. Der Hallsensor weist ein elektrisch isolierendes Gehäuse mit einer Öffnung auf. Das Befestigungselement wird in die Öffnung des isolierenden Hallsensorgehäuses gepresst. Aufgrund des Pressfits des elektrisch leitenden Befestigungselements mit dem elektrisch isolierenden Sensorgehäuse ist der Hallsensor mechanisch auf dem Befestigungselement befestigt.

In der DE 10 2004 013 659 A1 ist eine Sensoreinrichtung gezeigt, bei der ein erstes Verbindungselement mit einem Vorsprung in einer lochartigen Öffnung eines zweiten Verbindungselements verpresst wird.

Es ist daher Aufgabe der Erfindung, eine kostengünstige und zuverlässige Sensoreinrichtung bereit zu stellen, die die genannten Probleme beseitigt.

Die Aufgabe wird durch die Merkmale des unabhängigen Anspruchs gelöst. Bevorzugte Weiterbildungen sind Gegenstand der abhängigen Ansprüche, die durch Bezugnahme zum Gegenstand der Beschreibung gemacht werden.

Die erfindungsgemäße Sensoreinrichtung ermöglicht eine universelle Schnittstelle zu verschiedenen Varianten eines Masseanschlusses bzw. zweiten Verbindungselements, indem für alle Varianten eine lochartige Öffnung genutzt wird, in der das zweite Verbindungselement durch Einpressen fixiert wird. Hieraus ergibt sich eine hohe Modularität, da die erfindungsgemäße Sensoranordnung an viele verschieden ausgeführte Masseanschlusstypen angebunden werden kann, ohne dass die Sensoranordnung hierzu jeweils angepasst werden muss. Zudem wird die Herstellung einfach und kostengünstig, da bspw. auf Fügeverfahren wie Hartlöten verzichtet werden kann. Die Verbindung ist außerdem zuverlässig und sorgt durch den engen Kontakt in Folge des Einpressens für eine gute Stromleitung. Die lochartige Öffnung des ersten Verbindungselements und/oder die Verbindungsstelle des zweiten Verbindungselements sind derart geformt, dass sie bereichsweise ineinander verpressbar sind. Die Kontur der lochartigen Öffnung weist eine Form auf, die durch einander begrenzende Teilkreise gegeben ist, deren Mittelpunkte auf den Ecken eines Polygons liegen. Dadurch entstehen an der lochartigen Öffnung Presskanten, mit Hilfe derer die Verbindungsstelle des zweiten Verbindungselementes verdrehsicher fixiert ist.

Vorzugsweise wird die erfindungsgemäße Sensoreinrichtung derart weitergebildet, dass die Verbindungstelle des zweiten Verbindungselements eine zylindrische Grundform aufweist, die elastisch oder plastisch verformbar ist. Das ermöglicht einen einfachen Einpressvorgang in das erste Verbindungselement. Dies kann beispielsweise durch eine geeignete Materialausweil des zweiten Verbindungselements und / oder Dimensionierung der Verbindungsstelle oder des Kreisrings erreicht werden. Gemäß einer weiteren vorteilhaften Ausführungsform der erfindungsgemäßen Sensoreinrichtung weist die Verbindungsstelle des zweiten Verbindungselements eine Duktilität auf, die die Verbindungsstelle dazu befähigt, die Form der Kontur der lochartigen Öffnung des ersten Verbindungselements ganz oder teilweise einzunehmen. Die Fixierung des zweiten Verbindungselements wird damit sehr zuverlässig.

Die erfindungsgemäße Sensoreinrichtung wird dadurch in vorteilhafter Weise weitergebildet, dass die lochartige Öffnung und/oder die Verbindungsstelle konisch ausgebildet sind. Damit wird nach dem Prinzip der schrägen Ebene bzw. der Selbstverstärkung ein höherer radialer Anpressdruck erzeugt.

Gemäß einer Weiterbildung der Erfindung ist die Sensoreinrichtung eine Batteriesensoreinheit.

Vorzugsweise wird die erfindungsgemäße Sensoreinrichtung derart weitergebildet, dass senkrecht zur Einpressrichtung die größte Ausdehnung der Verbindungsstelle mindestens der kleinsten Ausdehnung der lochartigen Öffnung entspricht. Dies ist für die Einpressverbindung zweckmäßig.

Die erfindungsgemäße Sensoreinrichtung wird dadurch in vorteilhafter Weise weitergebildet, dass

Vorzugsweise ist die Verbindungsstelle des zweiten Verbindungselements als Hohlzylinder ausgebildet. Durch ein Druckelement innerhalb des Hohlzylinders kann somit direkt auf der Innenseite des Hohlzylinders eine Kraft bzw. ein Druck erzeugt werden, der den Einpressvorgang unterstützt oder bewerkstelligt. Verbleibt das Druckelement anschließend in dieser Stellung, so wird die Kraft bzw. der Druck über die Lebenszeit der Verbindung nicht abgebaut, da es eine innere Abstützung gibt.

Vorzugsweise bildet der Hohlzylinder durch einen Niet oder einen eingepressten Bolzen auf seiner Innenseite eine Pressverbindung mit dem ersten Verbindungselement.

Gemäß einer Weiterbildung der Erfindung weist der Hohlzylinder ein Innengewinde auf.

Nach einer bevorzugten Weiterbildung weist das Massenkontaktelement (4) eine Schraub- oder Schraube-Mutter-Verbindung an dem Innengewinde des Hohlzylinders auf.

Die erfindungsgemäße Sensoreinrichtung wird dadurch in vorteilhafter Weise weitergebildet, dass der Hohlzylinder als Blechkragen ausgeführt ist.

Gemäß einer weiteren vorteilhaften Ausführungsform weist der Blechkragen eine Wandstärke auf, die eine zum Verpressen ausreichende Verformung zulässt und/oder weist Schlitze auf, die eine zum Verpressen ausreichende Verformung zulassen.

Die erfindungsgemäße Sensoreinrichtung wird dadurch in vorteilhafter Weise weitergebildet, dass die Verbindungsstelle des zweiten Verbindungselements in Einpressrichtung über das erste Verbindungselement hinausragt und an ihrem hinausragenden Bereich als radialer Umschlag ausgebildet ist. Die Fixierung kann somit nach dem Niet-Prinzip oder durch Bördeln erfolgen.

Vorzugsweise liegt der radiale Umschlag dabei an dem ersten Verbindungselement an.

Gemäß einer weiteren vorteilhaften Ausführungsform der erfindungsgemäßen Sensoreinrichtung weist das zweite Verbindungselement weitestgehend eine flache oder eine runde Form auf. Diese Formvarianten sind gebräuchlich und einfach herstellbar.

Die Erfindung wird nachfolgend anhand vierer Ausführungsbeispiele und Zeichnungen näher beschrieben. Es zeigen in schematischer Darstellung
Fig. 1 eine Sensoreinrichtung gemäß dem Stand der Technik,
Fig. 2a eine Detailansicht einer lochartigen Öffnung eines ersten Ausführungsbeispiels.
Fig. 2b eine Darstellung von Fig. 2a mit Strichliniengeometrie zur Veranschaulichung.
Fig. 3 eine Schnittansicht des Massenkontaktelements der erfindungsgemäßen Sensoreinrichtung gemäß des ersten Ausführungsbeispiels.
Fig. 4 eine Schnittansicht des Massenkontaktelements der erfindungsgemäßen Sensoreinrichtung gemäß eines dritten Ausführungsbeispiels.
Fig. 5 eine Schnittansicht des Massenkontaktelements der erfindungsgemäßen Sensoreinrichtung gemäß eines vierten Ausführungsbeispiels.

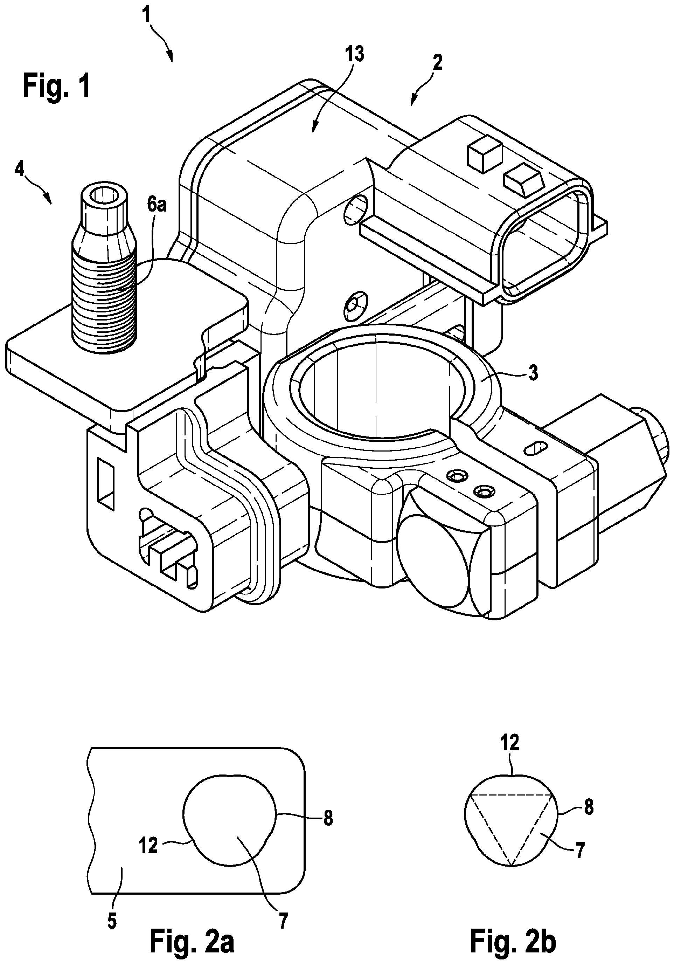

**Fig. 1** zeigt eine Sensoreinrichtung 1 gemäß dem Stand der Technik, aufweisend ein erstes Kontaktelement 3, ein Sensorelement 2 und ein Massenkontaktelement 4.

Bei der gezeigten Sensoreinrichtung 1 handelt es sich um eine Batteriesensoreinheit, die an eine nicht gezeigte Batterie eines Kraftfahrzeugs angeschlossen ist, um den Strom bzw. die Spannung der Batterie zu erfassen.

Der Anschluss an die Batterie erfolgt über das erste Kontaktelement 3 in Form einer Polklemme, welches zu diesem Zweck hülsenartig mit einer Innenkontur ausgeformt ist, die zum Pol der Batterie passt. Um einen festen Anschluss an den Pol zu gewährleisten, ist das Kontaktelement 3 so ausgebildet, dass es mit Hilfe einer Klemmschraube angezogen werden kann.

Das Sensorelement 2 in Form eines Messwiderstands ist in der Zeichnung durch ein Gehäuse verdeckt und ist sowohl mit dem Kontaktelement 3 als auch mit dem Massenkontaktelement 4 elektrisch leitend verbunden, so dass ein Stromfluss von der Batterie zur Masse ermöglicht wird.

Das Massenkontaktelement 4 umfasst einen Bolzen 6a mit einem Gewinde. An einem solchen Bolzen 6a kann mit Hilfe einer Mutter ein Massekabel befestigt werden. Zu diesem Zweck verfügt das Massekabel beispielsweise über einen Kabelschuh mit einem Loch durch das der Bolzen 6a geführt werden kann. Zum Fixieren wird anschließend die Mutter auf das Gewinde des Bolzens 6a geschraubt. Dies stellt eine von mehreren bisher üblichen Schnittstellen dar.

Die nachfolgend beschriebenen erfindungsgemäßen Ausführungsformen ermöglichen es, eine einheitliche Schnittstelle zu verwenden, die dabei kostengünstig herstellbar und sicher ist.

In **Fig 2a** ist eine lochartige Öffnung 7 eines ersten Verbindungselements 5 des Massenkontaktelements 4 einer erfindungsgemäßen Sensoreinrichtung 1 in einer Draufsicht zu sehen. Es ist erkennbar, dass die Kontur 8 von einer Kreisform abweicht. Die Kontur 8 enthält drei Presskanten 12, die ein verdrehen der eingepressten Verbindungsstelle 9 und damit des zweiten Verbindungselements 6 verhindern. Statt der Rastkante kann die Innenseite der Kontur mit Vorsprüngen, Wölbungen oder wulstförmigen Erhebungen ausgebildet sein. Da deren Außenkontur den durch die Presskanten 12 begrenzten Kreis der lochartigen Öffnung 9 übertrifft, wird die Oberfläche, insbesondere eine eventuelle Oxidschicht, der Verbindungsstelle 9 beim Einpressen des Verbindungselements 6, ähnlich wie bei einer PressFit-Kontaktierung an einer Leiterplatte, aufgerissen, was die Stromübertragung verbessert.

Die Formgebung der Kontur 8, die durch Teilkreise auf den Ecken eines Dreiecks beschrieben wird, ist in Fig 2b durch das gestrichelte Dreieck nochmals verdeutlicht. In anderen Worten kann die Kontur 8 auch derart beschrieben werden, dass sie sich aus mehreren Kreisbogenabschnitten zusammensetzt, die an den Ecken des Dreiecks, oder allgemein auch eines Polygons, angeordnet sind.

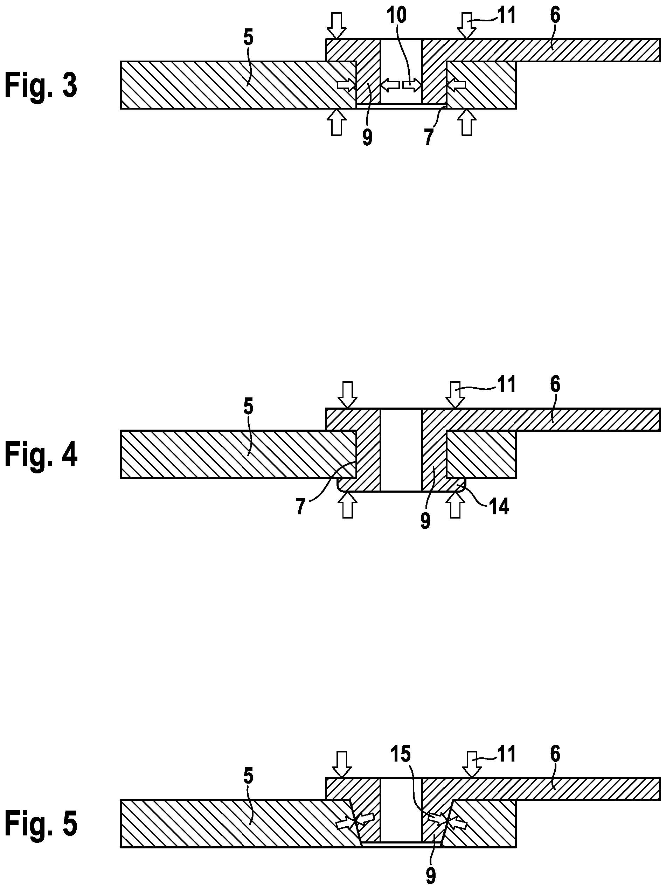

**Fig. 3** zeigt das in den Figuren 2a und 2b gezeigte Ausführungsbeispiel einer erfindungsgemäßen Sensoreinrichtung, bei der das zweite Verbindungselement 6 größtenteils flach ausgeführt ist und als Verbindungsstelle 9 einen zylindrischen Kragen aufweist, dessen Außendurchmesser zumindest etwas größer ist, als der kleinste freie Durchmesser der lochartigen Öffnung 7. Die Kontur der lochartigen Öffnung 7 ist in der Schnittdarstellung nicht zu erkennen, entspricht jedoch der in den Figuren 2 und 2a gezeigten Kontur.

Bei dem in dieser Darstellung bereits erfolgten Einpressvorgang wirken je nach angewendeter Methode durch Pfeile dargestellte axiale Kräfte 11 und/oder radiale Kräfte 10 auf das zweite Verbindungselement. Werden beispielsweise durch Anziehen einer Schraube-Mutter-Verbindung axiale Kräfte aufgebracht, so verformt sich aufgrund der drei Presskanten 12 einerseits die Verbindungsstelle 9, andererseits entstehen radiale Kräfte 10, die über den Umfang betrachtet unterschiedlich groß ausfallen. An den Presskanten 12 sind diese radialen Kräfte größer, an den Rundungen kleiner. Die für den Einpressvorgang benötigten axialen Kräfte 10 bleiben im Mittel daher auf einem herstellungstechnisch sinnvollen Niveau.

Durch die Verformung entsteht entlang des Umfangs zumindest ein geringer Formschluss, der ein Verdrehen des zweiten Verbindungselements 6 verhindert. Die kraftschlüssige Verbindung in Folge der radialen Kräfte 10 fixiert die Verbindungsstelle 9 und damit das zweite Verbindungselement 6 am ersten Verbindungselement 5.

Da das Auftreten der radialen Kräfte 10 für das Fixieren entscheidend ist, sind weitere nicht dargestellte Maßnahmen sinnvoll, die diese Kräfte verstärkten. Beispielsweise ist es denkbar, dass sich auf der Innenwand des zylindrischen Kragens ein Gewinde befindet, in das eine Schraube mit gewissem Übermaß eingedreht wird, so dass die radialen Kräfte 10 auf direktem Weg eingebracht werden. Dabei, wie auch bei anderen Einpressmethoden, ist durch eine konische Form von Verbindungsstelle 9 und/oder lochartiger Öffnung 7, die in Einpressrichtung nach unten zuläuft, eine Verstärkung der radialen Kräfte 10 möglich. Dieses Prinzip der Selbstverstärkung bzw. der schrägen Ebene kann auch dann genutzt werden, wenn die Konturen der Verbindungsstelle 9 und der lochartigen Öffnung 7 gleich verlaufen, also nicht die zuvor beschriebene Art der Verformung auftritt.

Da die lochartige Öffnung 7 so bemaßt ist, dass auch der in der Beschreibung von Fig. 1 erwähnte Bolzen darin verpresst werden kann, ist dieses Ausführungsbeispiel flexibel für alle gängigen Schnittstellen von Massenkontaktelementen anwendbar.

Ein zweites Ausführungsbeispiel ist in **Fig. 4** gezeigt. Die Verbindungsstelle 9 des ersten Verbindungselements 5 ist hier so ausgeführt, dass sie über das zweite Verbindungselement 6 hinausragt. Die Enden sind als radialer Umschlag 14, bzw. als an das erste Verbindungselement 5 gepresster Nietumschlag ausgebildet. Weitere Merkmale wurden bereits in Zusammenhang mit Fig. 3 behandelt und sollen an dieser Stelle nicht wiederholt werden.

**Fig. 5** zeigt ein drittes Ausführungsbeispiel, bei welchem die lochartige Öffnung 7 des ersten Verbindungselements 5, sowie die Verbindungsstelle 9 des zweiten Verbindungselements 6 konisch bzw. schräg ausgebildet ist. Die auf beliebige Weise aufgebrachten axialen Kräfte 11 wirken damit anteilig an den verpressten Flächen der Verbindungsstelle 9 des zweiten Verbindungselements 6 und der lochartigen Öffnung 7 des ersten Verbindungselements 5, bzw. sie unterstützen die radialen Kräfte in Form der schrägen Kräfte 15. Weitere gezeigte Merkmale dieses Ausführungsbeispiels entsprechen denen des ersten bzw. zweiten Ausführungsbeispiels und werden daher nicht wiederholt.

## Patentansprüche

1. Sensoreinrichtung (1) zum Messen eines Stromdurchflusses aufweisend,
- ein Sensorelement (2) zum Erfassen des Stromdurchflusses,
- ein erstes Kontaktelement (3) zum Verbinden des Sensorelements (2) mit einer Stromquelle,
- ein Massenkontaktelement (4) zum Verbinden des Sensorelements (2) mit einer Masse, wobei das Massenkontaktelement (4) ein erstes (5) und zweites elektrisch leitfähiges Verbindungselement (6) umfasst,
wobei das erste Verbindungselement (5) eine lochartige Öffnung (7) aufweist und
wobei das zweite Verbindungselement (6) eine Verbindungsstelle (9) aufweist, die in die lochartige Öffnung (7) des ersten Verbindungselements (5) einpressbar ist, so dass das zweite Verbindungselement (6) an dem ersten Verbindungselement (5) fixiert ist, **dadurch gekennzeichnet, dass** die Kontur (8) der lochartigen Öffnung (7) eine Form aufweist, die durch einander begrenzende Teilkreise gegeben ist, deren Mittelpunkte auf den Ecken eines Polygons liegen, so dass dadurch an der lochartigen Öffnung (7) Presskanten (12) entstehen, mit Hilfe derer die Verbindungsstelle (9) des zweiten Verbindungselementes (6) verdrehsicher fixiert ist.

2. Sensoreinrichtung (1) nach einem der vorhergehenden Ansprüche, wobei die Verbindungstelle (9) des zweiten Verbindungselements (6) eine zylindrische Grundform aufweist, die elastisch oder plastisch verformbar ist.

3. Sensoreinrichtung (1) nach Anspruch 2, wobei die Verbindungsstelle (9) des zweiten Verbindungselements (6) eine Duktilität aufweist, die die Verbindungsstelle (9) dazu befähigt, die Form der Kontur (8) der lochartigen Öffnung (7) des ersten Verbindungselements (5) ganz oder teilweise einzunehmen.

4. Sensoreinrichtung (1) nach einem der vorhergehenden Ansprüche, wobei die lochartige Öffnung (7) und/oder die Verbindungsstelle (9) konisch ausgebildet sind.

5. Sensoreinrichtung (1) nach einem der vorhergehenden Ansprüche, wobei die Sensoreinrichtung (1) eine Batteriesensoreinheit ist.

6. Sensoreinrichtung (1) nach einem der vorhergehenden Ansprüche, wobei senkrecht zur Einpressrichtung die größte Ausdehnung der Verbindungsstelle (9) mindestens der kleinsten Ausdehnung der lochartigen Öffnung (7) entspricht.

7. Sensoreinrichtung (1) nach einem der vorhergehenden Ansprüche, wobei die Verbindungsstelle (9) des zweiten Verbindungselements (6) als Hohlzylinder ausgebildet ist.

8. Sensoreinrichtung (1) nach Anspruch 7, wobei der Hohlzylinder durch einen Niet oder einen eingepressten Bolzen auf seiner Innenseite eine Pressverbindung mit dem ersten Verbindungselement (5) bildet.

9. Sensoreinrichtung (1) nach Anspruch 7, wobei der Hohlzylinder ein Innengewinde aufweist.

10. Sensoreinrichtung (1) nach Anspruch 9, wobei das Massenkontaktelement (4) eine Schraub- oder Schraube-Mutter-Verbindung an dem Innengewinde des Hohlzylinders aufweist.

11. Sensoreinrichtung (1) nach Anspruch 7, wobei der Hohlzylinder als Blechkragen ausgeführt ist.

12. Sensoreinrichtung (1) nach Anspruch 11, wobei der Blechkragen eine Wandstärke aufweist, die eine zum Verpressen ausreichende Verformung zulässt und/oder Schlitze aufweist, die eine zum Verpressen ausreichende Verformung zulassen.

13. Sensoreinrichtung (1) nach einem der vorhergehenden Ansprüche, wobei die Verbindungsstelle (9) des zweiten Verbindungselements (6) in Einpressrichtung über das erste Verbindungselement (5) hinausragt und an ihrem hinausragenden Bereich als radialer Umschlag (14) ausgebildet ist.

## Claims

1. Sensor device (1) for measuring a current flow, having
- a sensor element (2) for detecting the current flow,
- a first contact element (3) for connecting the sensor element (2) to a current source,
- a ground contact element (4) for connecting the sensor element (2) to ground, wherein the ground contact element (4) comprises a first (5) and second electrically conductive connecting element (6),
wherein the first connecting element (5) has a hole-like opening (7), and
wherein the second connecting element (6) has a connecting point (9) which can be pressed into the hole-like opening (7) of the first connecting element (5) such that the second connecting element (6) is fixed to the first connecting element (5), **characterized in that** the contour (8) of the hole-like opening (7) has a shape defined by circular segments adjoining one another, the central points of which lie on the corners of a polygon, such that, at the hole-like opening (7), pressing edges (12) thus form by means of which the connecting point (9) of the second connecting element (6) is fixed in a rotationally secured manner.

2. Sensor device (1) according to one of the preceding claims, wherein the connecting point (9) of the second connecting element (6) has a cylindrical basic shape which is elastically or plastically deformable.

3. Sensor device (1) according to Claim 2, wherein the connecting point (9) of the second connecting element (6) exhibits ductility which enables the connecting point (9) to entirely or partially adopt the shape of the contour (8) of the hole-like opening (7) of the first connecting element (5).

4. Sensor device (1) according to one of the preceding claims, wherein the hole-like opening (7) and/or the connecting point (9) are of conical form.

5. Sensor device (1) according to one of the preceding claims, wherein the sensor device (1) is a battery sensor unit.

6. Sensor device (1) according to one of the preceding claims, wherein, perpendicular to the pressing-in direction, the greatest extent of the connecting point (9) corresponds at least to the smallest extent of the hole-like opening (7).

7. Sensor device (1) according to one of the preceding claims, wherein the connecting point (9) of the second connecting element (6) is formed as a hollow cylinder.

8. Sensor device (1) according to Claim 7, wherein the hollow cylinder, by means of a rivet or a pressed-in bolt on its inner side, forms an interference-fit connection with the first connecting element (5).

9. Sensor device (1) according to Claim 7, wherein the hollow cylinder has an internal thread.

10. Sensor device (1) according to Claim 9, wherein the ground contact element (4) has a screw or screw-nut connection to the internal thread of the hollow cylinder.

11. Sensor device (1) according to Claim 7, wherein the hollow cylinder is formed as a sheet-metal flange.

12. Sensor device (1) according to Claim 11, wherein the sheet-metal flange has a wall thickness which permits a deformation adequate for the pressing-together and/or has slots which permit a deformation adequate for the pressing-together.

13. Sensor device (1) according to one of the preceding claims, wherein the connecting point (9) of the second connecting element (6) projects beyond the first connecting element (5) in the pressing-in direction, and is formed at its projecting region as a radial collar (14) .

## Revendications

1. Dispositif de détection (1) destiné à mesurer un flux de courant, ledit dispositif de détection comportant
- un élément de détection (2) destiné à détecter le flux de courant,
- un premier élément de contact (3) destiné à relier l'élément de détection (2) à une source de courant,
- un élément de contact de masse (4) destiné à relier l'élément de détection (2) à une masse, l'élément de contact de masse (4) comprenant un premier (5) et un deuxième élément de liaison électriquement conducteur (6),
le premier élément de liaison (5) comportant une ouverture (7) en forme de trou et
le deuxième élément de liaison (6) comportant un point de liaison (9) qui peut être enfoncé dans l'ouverture (7) en forme de trou du premier élément de liaison (5) de sorte que le deuxième élément de liaison (6) soit fixé au premier élément de liaison (5), **caractérisé en ce que** le contour (8) de l'ouverture (7) en forme de trou a une forme qui est donnée par des parties de cercle se délimitant les uns les autres, dont les centres se trouvent sur les coins d'un polygone de façon à générer au niveau de l'ouverture (7) en forme de trou des bords de pression (12) au moyen desquels le point de liaison (9) du deuxième élément de liaison (6) est bloqué en rotation.

2. Dispositif de détection (1) selon l'une des revendications précédentes, le point de liaison (9) du deuxième élément de liaison (6) a une forme de base cylindrique qui est élastiquement ou plastiquement déformable.

3. Dispositif de détection (1) selon la revendication 2, le point de liaison (9) du deuxième élément de liaison (6) ayant une ductilité qui permet au point de liaison (9) de prendre entièrement ou partiellement la forme du contour (8) de l'ouverture (7) en forme de trou du premier élément de connexion (5).

4. Dispositif de détection (1) selon l'une des revendications précédentes, l'ouverture (7) en forme de trou et/ou le point de liaison (9) étant coniques.

5. Dispositif de détection (1) selon l'une des revendications précédentes, le dispositif de détection (1) étant une unité de détection de batterie.

6. Dispositif de détection (1) selon l'une des revendications précédentes, la plus grande étendue du point de liaison (9) correspondant au moins à la plus petite étendue de l'ouverture (7) en forme de trou, perpendiculairement à la direction d'enfoncement.

7. Dispositif de détection (1) selon l'une des revendications précédentes, le point de liaison (9) du deuxième élément de liaison (6) étant réalisé sous la forme d'un cylindre creux.

8. Dispositif de détection (1) selon la revendication 7, le cylindre creux formant sur son côté intérieur une liaison serrée avec le premier élément de liaison (5) à l'aide d'un rivet ou d'un boulon enfoncé.

9. Dispositif de détection (1) selon la revendication 7, le cylindre creux comportant un filetage intérieur.

10. Dispositif de détection (1) selon la revendication 9, l'élément de contact de masse (4) comportant une liaison à vis ou à vis-écrou au niveau du filetage intérieur du cylindre creux.

11. Dispositif de détection (1) selon la revendication 7, le cylindre creux étant réalisé sous la forme d'une collerette en tôle.

12. Dispositif de détection (1) selon la revendication 11, la collerette en tôle ayant une épaisseur de paroi qui permet une déformation suffisante pour l'emboutissage et/ou des fentes qui permettent une déformation suffisante pour l'emboutissage.

13. Dispositif de détection (1) selon l'une des revendications précédentes, le point de liaison (9) du deuxième élément de liaison (6) faisant saillie du premier élément de liaison (5) dans la direction d'enfoncement et étant conçu comme une enveloppe radiale (14) au niveau de sa zone saillante.
